Europäisches Patentamt

European Patent Office

Office européen des brevets

(11) Publication number: **0 160 525 B1**

# EUROPEAN PATENT SPECIFICATION

(45) Date of publication of patent specification: **17.06.92**

(51) Int. Cl.5: **H01L 29/743**, H01L 29/167, H01L 29/36

(21) Application number: **85302920.5**

(22) Date of filing: **25.04.85**

The file contains technical information submitted after the application was filed and not included in this specification

(54) A gate turn-off Thyristor and a method of producing the same.

(30) Priority: **27.04.84 JP 86830/84**

(43) Date of publication of application:
**06.11.85 Bulletin 85/45**

(45) Publication of the grant of the patent:
**17.06.92 Bulletin 92/25**

(84) Designated Contracting States:
**DE FR GB**

(56) References cited:
**US-A- 3 860 947**

**IEEE ELECTRON DEVICE LETTERS, vol. EDL-1, no. 10, October 1980, pages 203-205, IEEE, New York, US; M. AZUMA et al.: "Anode current limiting effect of high power GTOs"**

**IEEE TRANSACTIONS ON ELECTRON DEVICES, vol. ED-28, no. 3, March 1981, pages 270-274, IEEE, New York, US; M. AZUMA et al.: "2500-V 600-A gate turn-off thyristor (GTO)"**

(73) Proprietor: **MITSUBISHI DENKI KABUSHIKI KAISHA**
**2-3, Marunouchi 2-chome Chiyoda-ku Tokyo 100(JP)**

(72) Inventor: **Hagino, Hiroyasu**
**11-2, Takamatsu-cho**
**Nishinomiya-shi Hyogo-ken(JP)**

(74) Representative: **Beresford, Keith Denis Lewis et al**
**BERESFORD & Co. 2-5 Warwick Court High Holborn**
**London WC1R 5DJ(GB)**

**Description**

The present invention concerns improvements in or relating to gate turn-off thyristors (hereinafter referred to as "GTO's") and to methods of producing the same. In particular it concerns GTO's having an anode short-circuited structure.

High power GTO's are of especial interest in the power electronics technical field because their self turn-off capability provides an advance over standard thyristors that require current interruption by forced comutation circuits or other means.

There is currently a demand for GTO's for high power applications in which high blocking voltages are an essential requisite. Furthermore it is required of such GTO's that they should have excellent turn-off characteristics so as to be capable of both rapid response and high frequency operation.

Anode short circuited GTO's have advantages of low on-state voltage and a turn-off time that is particularly short. Particular reference is made to United States Patent No 3303360 in which there is described a semiconductor switch in which anode short circuited structure is adopted as a means of improving the turn-off characteristic of the GTO switch. Mention is also made of Japanese Laid Open Patent Specification No 58-148086. The GTO described therein has an anode short circuited structure in which a short circuited emitter is provided directly below the n-type emitter. This latter structure improves the turn-off characteristic without concomittant increase in the on-state voltage VTM.

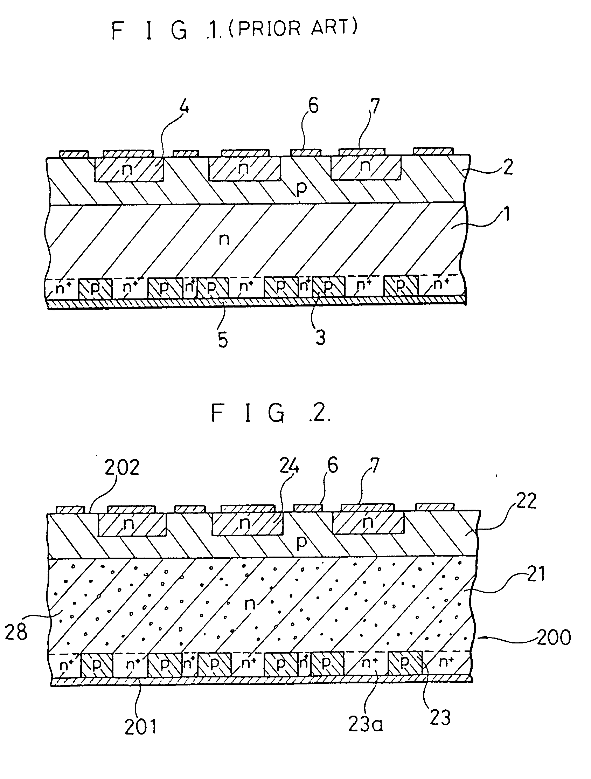

An anode short circuited GTO of typical known structure is shown in Figure 1 of the accompanying drawings. This GTO comprises an n-type silicon substrate which provides the n-type base region 1 of the GTO. On this n-type base region is formed a p-type base region 2. On the reverse side of the n-type base region 1 a plurality of p-type emitter regions 3 are provided. A plurality of n-type emitter regions 4 are provided at the surface of the p-type base region 2. An anode electrode 5 is provided in ohmic contact with the p-type emitters 3. Gate electrodes 6 are provided in ohmic contact with the p-type base region 2 and cathode electrodes 7 are provided in ohmic contact with each of the n-type emitters 4. In this type of structure the anode electrode 5 is also electrically connected to the n-type base region 1. In the device shown electrical connection is provided between the n-type base region 1 and the anode electrode 5 via heavily doped n-type regions n+.

The anode short circuited gate turn-off thyristor just described thus has the following features in common with the invention that is to be described below (Figure 2):

A first n-type impurity region 24, a second p-type impurity region 22, a third n-type impurity region 21, and a fourth p-type impurity region 23 produced in a semiconductor substrate in the above-mentioned order from the side of the first main surface of the semiconductor substrate, a cathode electrode 7 provided in contact with the first n type impurity region 24, a gate electrode 6 provided in contact with the second p type impurity region 22, and an anode electrode 5 which short-circuits the third region 21 and the fourth region 23 at the second main surface of the semiconductor substrate.

In GTO's of conventional anode short circuited structure, such as that described with reference to Figure 1, carriers in the n-type base region 1 are extracted through the anode short circuited portion in turn-off operation. As a consequence it has been possible to realise both a low on-state voltage and a reduced turn-off time by comparison with GTO's having an ordinary anode configuration.

Since in conventional anode short circuited GTO's the n-type base region 1 is inherently thin, the blocking voltage exhibited by these structures is limited and not therefore compatible with the recent demands for high power and in consequence high blocking voltage.

The present invention is intended to provide an anode short circuited GTO having a high blocking voltage without increasing turn-off loss and minimum turn-off time.

In accordance with the present invention thus there is provided an anode short circuited gate turn-off thyristor having the common structure just recited wherein the third region has a thickness of at least 250 $\mu$m; and the third region includes gold dopant to shorten the carrier lifetime thereof.

A method of producing such a thyristor is set out in claim 2.

This improved modification thus relies on the combination of two features. First, the third region i.e. the n-type base region is of a greater thickness than is conventional for anode short circuited structure GTO's. Secondly gold dopant is included to shorten the lifetime of carriers in the n-type base region. It was found in preliminary development that the provision of a thicker n-type base region alone was inadequate to meet the above specified requirements, and in particular the requirement of rapid turn-off. Although by using a thickened n-type base region an increased blocking voltage resulted, the turn-off characteristic of such a device was significantly degraded. The tail current in gate turn-off operation was altogether too lengthy resulting in an increased turn-off loss and an increased minimum turn-off time. This consequential problem has been resolved by including gold dopant to shorten the lifetime of the remanant carriers.

2

By way of acknowledgment mention is made of a published paper entitled "2500-V 600-A Gate Turn-Off Thyristor (GTO)" Azuma et al, IEEE Transactions on Electron Devices, vol. ED-28, no 3, March 1981, pages 270-274. In this article a gate turn-off thyristor of ordinary anode structure is described in which the n-type base region is inherently thick and so chosen to achieve an increase in blocking voltage. Diffusion of gold dopant is also described as a means of decreasing lifetime of carriers in the n-type base region.

In the accompanying drawings:

Figure 1 is a cross-sectional view showing a GTO wafer of a prior art GTO;

Figure 2 is a cross-sectional view showing a GTO wafer of one embodiment of the present invention;

Figure 3 is a graph showing the characteristics between the turn-off loss Poff or the ON-voltage VTM and the gold diffusion temperature; and

Figure 4 is a graph showing the characteristics between the on-state-voltage VTM and the minimum turn-off time.

So that the invention may be better understood, embodiments thereof will now be described and reference will be made to the drawings aforesaid. The description that follows is given by way of example only.

A method of producing a GTO as one embodiment of the present invention will be described in detail with reference to Figure 2 which shows a cross-section of the GTO.

At first, p type regions (one is designated by 22) are produced at both surfaces of an n type silicon substrate 21 by diffusing p type impurities such as gallium or aluminium. Thereafter, the p type region at the opposite side of the substrate to p type region 22 is removed by lapping or the like to produce a silicon wafer 200 comprising the n type silicon substrate 21 and the p type region 22, and a predetermined pattern is produced at the surface (the anode surface 201) to which the lapping is conducted. Thereafter, p type impurities such as boron are diffused to produce p type emitter regions 23. Hereupon, in producing the p type emitter regions 23, the following can be conducted; that is, $n^+$ regions 23a at the anode short-circuited portion are selectively produced, and p type impurities such as gallium are diffused to the whole surface thereof, thereby producing the p type emitter regions 23. In this case it is necessary that the density of the n type impurities in the $n^+$ regions 23a are sufficiently higher than that of the p type impurities in the p type emitter regions 23. Thereafter, an anode electrode 5 is produced at the anode surface 201 of the silicon wafer 200.

Thereafter, n type emitter regions 24 are produced at predetermined positions of the exposed surface (cathode surface 202) of the p-type region 22 by diffusion of n type impurities.

Thereafter, gold 28 is diffused into the n type base region 21 thereby to shorten the life time of carriers in the n type base region 21. This gold doping is conducted in such a manner that after insulating film at the anode surface 201 of the silicon wafer 200 to which the diffusion of n type impurities is conducted is completely removed by fluoric acid or the like, gold is formed on the anode surface 201 by deposition or the like, and the gold is diffused into the silicon wafer 200 in a diffusion oven. The quantity of the gold doping is determined by the diffusion time and the diffusion temperature, and it can be controlled by changing the diffusion temperature in each of 25 to 30 minutes.

In this way, a GTO is produced comprising a first n type impurity region 24, a second p type impurity region 22, a third n type impurity region 21, and a fourth p type impurity region 23 produced in a semiconductor substrate 200 in the above-mentioned order from the side of a first principal surface of the semiconductor substrate, a cathode electrode 7 provided in contact with the first n type impurity region 24, a gate electrode 6 provided in contact with the second p type impurity region 22, and an anode electrode 5 which short-circuits the third region 21 and the fourth region 23 at a second principal surface thereof.

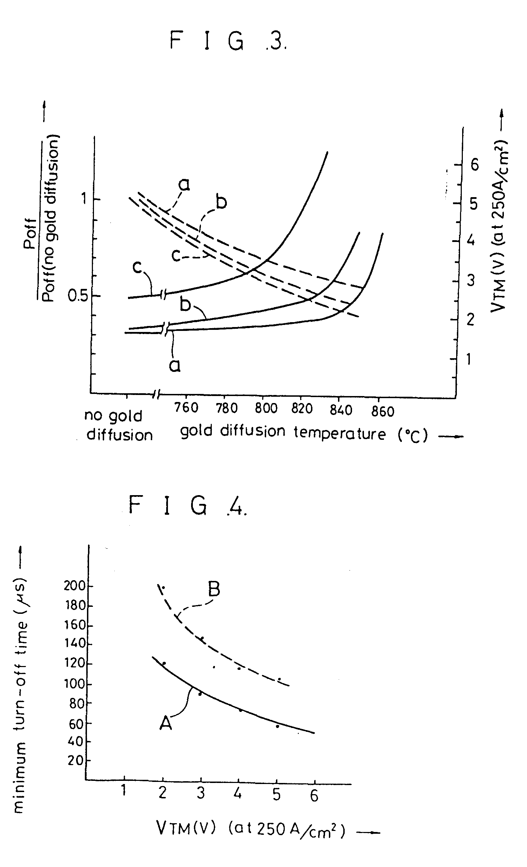

The curves a in Figure 3 show characteristics for the turn-off loss [Poff] (in broken line) and the ON voltage VTM (in solid line), as a function of gold diffusion temperature in GTOs having blocking voltage of 1000 to 2000 volt. In GTOs having blocking voltage of 1000 to 2000 volt, the resistivity of the silicon substrate is usually set to about 50 to 100$\Omega\cdot$cm, and the thickness of the n type base layer is usually set to about 250 to 300$\mu$m in GTOs having a cut-off current above several hundreds amperes, varying depending on the cut-off current. In the Figure, it is shown that the on-state voltage VTM increases rapidly from a gold diffusion temperature of about 845°C. On the other hand, the turn-off loss [Poff] decreases with the rising of the gold diffusion temperature. Considering both characteristics, in GTOs having a blocking voltage of 1000 to 2000 volt, it is possible to improve the correlation between the turn-off loss [Poff] and the on-state voltage VTM by diffusing gold at the diffusion temperature of 820 to 845°C, thereby resulting in a reduced turn-off loss [Poff] without increasing the on-state voltage VTM.

The curves b in Figure 3 show the characteristics for the [Poff] and the VTM, as a function of gold diffusion temperature in GTOs having blocking voltage of 2000 to 3000 volt. In GTOs having the blocking voltage of 2000 to 3000 volt, silicon substrates having a resistivity of 100 to 160$\Omega\cdot$cm are usually used, and the thickness of the n type base layer is usually set to about 350 to 450$\mu$m in GTOs having a cut-off current above several hundreds amperes, varying depending on the cut-off current. In this case, the VTM increases rapidly at a gold diffusion temperature of about 830°C. Accordingly, in GTOs having a blocking voltage of 2000 to 3000 volt, it is most preferable to conduct gold diffusion at a temperature of 800 to 830°C.

The curves c in Figure 3 show the characteristics for the [Poff] and the VTM, as a function of gold diffusion temperature in GTOs having a blocking voltage of 3000 to 5000 volt. In GTOs having a blocking voltage of 3000 to 5000 volt, a silicon substrate which has resistivity of 160 to 250$\Omega\cdot$cm is usually used, and the thickness of the n type base layer is set to about 450 to 600$\mu$m in GTOs having a cut-off current above several hundreds amperes, varying depending on the cut-off current. In this case, the VTM rapidly increases at a gold diffusion temperature of about 810°C. Accordingly, in GTOs having a blocking voltage of 3000 to 5000 volt, it is most preferable to conduct a gold diffusion at a temperature of 760 to 810°C.

Besides, there is a relation represented by the following formula among the three parameters of the width of the n type base region WnB, the gold diffusion temperature T, and the on-state voltage VTM:

$$VTM = \frac{KT}{q} \ln \frac{I}{Iso} + \frac{KT}{q} \left( \delta \cdot e^{\frac{WnB}{2L}} + IR_K \right) \quad \ldots \quad (1)$$

$$L = D\tau p$$

$$\tau p = \frac{1}{\alpha_p N_{Au}}$$

where,

L: diffusion length
D: diffusion coefficient
$\tau$p: life time
$\alpha$p: trap probability of holes
I: current
Iso: leak current
NAu: concentration of gold

The concentration of gold NAu is determined by the gold diffusion temperature T, but there is no general formula which represents the relation therebetween. On the other hand, there are relations between the blocking voltage V and the width of the vacant layer $x_m$, and between the width $x_m$ and the width of the n type base layer WnB represented by the following formulae, respectively:

$$x_m = \sqrt{\frac{2k\varepsilon_0 V}{q N_D}} \quad \ldots \quad (2)$$

$$WnB = x_m + \alpha \quad (3)$$

Where, the $\alpha$ is a margin which is set to about 100 m in a usual design.
The resistivity $\rho$

$$\rho = \frac{1}{q\mu (N_D - Na)}$$

is determined by the required blocking voltage V, where $N_D$, Na are concentrations of donors and acceptors, respectively.

Figure 4 shows the characteristic between the minimum turn-off time and the VTM for a GTO having anode short-circuited structure, and also a characteristic for a conventional reverse blocking GTO. Both of these have a blocking voltage of between 3000 and 5000 volt. Curve A shows a characteristic for a GTO obtained by diffusing gold into a GTO having the anode short-circuited structure to control the life-time of carriers in the base region. Curve B shows a characteristic for a reverse blocking GTO. As apparent from curve A, the GTO of this embodiment has a significantly reduced minimum turn-off time, that is, the minimum time period measured from the input of the gate-off signal to the next ON signal input in a condition of the same VTM. This indicates that the GTO having the anode short-circuited structure produced by the gold diffusion has the advantage of being more suitable for high frequency operation.

As apparent from the foregoing, according to the present invention, a thicker n type base region is adopted and the life-time of carriers in the n type base region is shortened by gold diffusion conducted at a predetermined temperature. This results in reduced turn-off loss without a concommitant increase in the ON voltage, and furthermore, results in an enhancement of the turn-off characteristic.

## Claims

1. An anode short-circuited gate turn-off thyristor comprising a first n-type impurity region (24), a second p-type impurity region (22), a third n-type impurity region (21), and a fourth p-type impurity region (23) formed in a semiconductor substrate in the above-mentioned order from the side of the first main surface of the semiconductor substrate, a cathode electrode (7) provided in contact with the first n type impurity region (24), a gate electrode (6) provided in contact with the second p-type impurity region (22), and an anode electrode (5) which short-circuits the third region (21) and the fourth region (23) at the second main surface of the semiconductor substrate, characterised in that the third region (21) has a thickness of at least 250 $\mu$m and is doped with gold to shorten the life-time of carriers in the third region.

2. A method of producing a gate turn-off thyristor comprising the steps of forming a first n-type impurity region (24), a second p-type impurity region (22), a third n-type impurity region (21), and a fourth p-type impurity region (23) in a semiconductor substrate in the above-mentioned order from the side of the first main surface of the semiconductor substrate, and providing a cathode electrode (7) in contact with the first n-type impurity region (24), a gate electrode (6) in contact with the second p type impurity region (22), and an anode electrode (5) which short-circuits the third region (21) and the fourth region (23) at the second main surface of the semiconductor substrate, which method is characterised in that the third region is formed to a thickness of at least 250 $\mu$m and gold is diffused into the third region (21) at a predetermined diffusion temperature, thereby to shorten the life-time of carriers in the third region.

3. A method of producing a gate turn-off thyristor as claimed in claim 2, wherein the gold diffusion is carried out at a temperature from 820 to 845ºC for a GTO having a blocking voltage of 1000 to 2000 volt and a third region thickness of 250 to 300 $\mu$m.

4. A method of producing a gate turn-off thyristor as claimed in claim 2, wherein the gold diffusion is carried out at a temperature from 800 to 830ºC for a GTO having a blocking voltage of 2000 to 3000 volt and a third region thickness of 350 to 450 $\mu$m.

5. A method of producing a gate turn-off thyristor as claimed in claim 2, wherein the gold diffusion is carried out at a temperature from 760 to 810ºC for a GTO having a blocking voltage of 3000 to 5000 volt and a third region thickness of 450 to 600 $\mu$m.

## Revendications

1. Un thyristor à gain de commande à l'ouverture ayant une structure court-circuitée par l'anode, comprenant une première région d'impureté de type n (24), une seconde région d'impureté de type p (22), une troisième région d'impureté de type n (21) et une quatrième région d'impureté de type p (23) formées dans un substrat semiconducteur dans l'ordre mentionné ci-dessus, à partir du côté de la première surface principale du substrat semiconducteur, une électrode de cathode (7) formée en contact avec la première région d'impureté de type n (24), une électrode de gâchette (6) formée en

EP 0 160 525 B1

contact avec la seconde région d'impureté de type p (22), et une électrode d'anode (5) qui court-circuite la troisième région (21) et la quatrième région (23) au niveau de la seconde surface principale du substrat semiconducteur, caractérisé en ce que la troisième région (21) a une épaisseur d'au moins 250 $\mu$m, et elle est dopée avec de l'or pour raccourcir la durée de vie des porteurs dans la troisième région.

2. Un procédé de fabrication d'un thyristor à gain de commande à l'ouverture, comprenant les étapes qui consistent à former une première région d'impureté de type n (24), une seconde région d'impureté de type p (22), une troisième région d'impureté de type n (21) et une quatrième région d'impureté de type p (23) dans un substrat semiconducteur, dans l'ordre mentionné ci-dessus, à partir du côté de la première surface principale du substrat semiconducteur, et à former une électrode de cathode (7) en contact avec la première région d'impureté de type n (24), une électrode de gâchette (6) en contact avec la seconde région d'impureté de type p (22), et une électrode d'anode (5) qui court-circuite la troisième région (21) et la quatrième région (23) au niveau de la seconde surface principale du substrat semiconducteur, ce procédé étant caractérisé en ce que la troisième région est formée avec une épaisseur d'au moins 250 $\mu$m, et de l'or est diffusé dans la troisième région (21) à une température de diffusion prédéterminée, pour raccourcir ainsi la durée de vie des porteurs dans la troisième région.

3. Un procédé de fabrication d'un thyristor à gain de commande à l'ouverture selon la revendication 2, dans lequel la diffusion d'or est effectuée à une température comprise entre 820 et 845°C, dans le cas d'un thyristor à gain de commande à l'ouverture ayant une tension de blocage de 1000 à 2000 volts, et une épaisseur de la troisième région de 250 à 300 $\mu$m.

4. Un procédé de fabrication d'un thyristor à gain de commande à l'ouverture selon la revendication 2, dans lequel la diffusion d'or est effectuée à une température comprise entre 800 et 830°C pour un thyristor à gain de commande à l'ouverture ayant une tension de blocage de 2000 à 3000 volts et une épaisseur de la troisième région de 350 à 450 $\mu$m.

5. Un procédé de fabrication d'un thyristor à gain de commande à l'ouverture selon la revendication 2, dans lequel la diffusion d'or est effectuée à une température comprise entre 760 et 810°C pour un thyristor à gain de commande à l'ouverture ayant une tension de blocage de 3000 à 5000 volts et une épaisseur de la troisième région de 450 à 600 $\mu$m.

**Patentansprüche**

1. GTO-Thyristor mit kurzgeschlossener Anode mit einem ersten n-Typ-Dotierstoffbereich (24), einem zweiten p-Typ-Dotierstoffbereich (22), einem dritten n-Typ-Dotierstoffbereich (21) und einem vierten p-Typ-Dotierstoffbereich (23), die in einem Halbleitersubstrat in der obigen Reihenfolge von der Seite der ersten Hauptoberfläche des Halbleitersubstrates gebildet sind, einer in Kontakt mit dem ersten n-Typ-Dotierstoffbereich (24) vorgesehenen Kathodenelektrode (7), einer in Kontakt mit dem zweiten p-Typ-Dotierstoffbereich (22) vorgesehenen Gateelektrode (6) und einer Anodenelektrode (5), die den dritten Bereich (21) und den vierten Bereich (23) an der zweiten Hauptoberfläche des Halbleitersubstrates kurzschließt, dadurch gekennzeichnet, daß der dritte Bereich (21) eine Dicke von mindestens 250 $\mu$m aufweist und mit Gold zum Verkürzen der Lebensdauer der Ladungsträger in dem dritten Bereich dotiert ist.

2. Verfahren zum Herstellen eines GTO-Thyristors mit den Schritten des Bildens eines ersten n-Typ-Dotierstoffbereiches (24), eines zweiten p-Typ-Dotierstoffbereiches (22), eines dritten n-Typ-Dotierstoffbereiches (21) und eines vierten p-Typ-Dotierstoffbereiches (23) in einem Halbleitersubstrat in der obigen Reihenfolge von der Seite der ersten Hauptoberfläche des Halbleitersubstrates und Vorsehen einer Kathodenelektrode (7) in Kontakt mit dem ersten n-Typ-Dotierstoffbereich (24), einer Gateelektrode (6) in Kontakt mit dem zweiten p-Typ-Dotierstoffbereich (22) und einer Anodenelektrode (5), die den dritten Bereich (21) und den vierten Bereich (23) an der zweiten Hauptoberfläche des Hauptleitersubstrates kurzschließt, wobei das Verfahren dadurch gekennzeichnet ist, daß der dritte Bereich bis zu einer Dicke von mindestens 250 $\mu$m gebildet wird und Gold in den dritten Bereich (21) bei einer vorbestimmten Diffusionstemperatur diffundiert wird, wodurch die Lebensdauer der Ladungsträger in dem dritten Bereich verkürzt wird.

3. Verfahren zum Herstellen eines GTO-Thyristors nach Anspruch 2, bei dem die Golddiffusion bei einer Temperatur von 820 - 845 °C für einen GTO mit einer Sperrspannung von 1 000 - 2 000 V und einer Dicke des dritten Bereiches von 250 - 300 $\mu$m ausgeführt wird.

4. Verfahren zum Herstellen eines GTO-Thyristors nach Anspruch 2, bei dem die Golddiffusion bei einer Temperatur von 800 - 830 °C für einen GTO mit einer Sperrspannung von 2 000 - 3 000 V und einer Dicke des dritten Bereiches von 350 - 450 $\mu$m ausgeführt wird.

5. Verfahren zum Herstellen eines GTO-Thyristors nach Anspruch 2, bei dem die Golddiffusion bei einer Temperatur von 760 - 810 °C für einen GTO mit einer Sperrspannung von 3 000 - 5 000 V und einer Dicke des dritten Bereiches von 450 - 600 $\mu$m ausgeführt wird.

## F I G .1. (PRIOR ART)

## F I G .2.

EP 0 160 525 B1

F I G .3.

F I G .4.

9